# EUROPÄISCHE PATENTSCHRIFT

(11) **EP 1 705 687 B1**
(45) Veröffentlichungstag und Bekanntmachung des Hinweises auf die Patenterteilung: **09.05.2007**
(21) Anmeldenummer: 05006680.2
(22) Anmeldetag: 26.03.2005
(51) Int. Cl.: H01J 37/32, H01J 37/34

(54) **Verfahren zur Arcerkennung**
Method of Arc Detection
Procédé de détection d'arc

(43) Veröffentlichungstag der Anmeldung: 27.09.2006
(73) Patentinhaber: HÜTTINGER Elektronik GmbH + Co. KG, 79111 Freiburg (DE)
(72) Erfinder: Axenbeck, Sven, 79395 Neuenburg (DE); Bannwarth, Markus, 79115 Freiburg (DE); Steuber, Martin, 79426 Buggingen (DE); Trusch, Alfred, 79206 Breisach (DE); Wolf, Lothar, 79361 Sasbach (DE); Wiedemuth, Peter, Dr., 79336 Herbolzheim (DE); Zähringer, Gerhard, 79112 Freiburg (DE)
(74) Vertreter: Kohler Schmid Möbus

(56) Entgegenhaltungen:
- EP-A- 1 441 576
- WO-A-99/14394
- US-B1- 6 420 863

## Beschreibung

Die Erfindung betrifft ein Verfahren zur Arcerkennung gemäß dem Oberbegriff von Patentanspruch 1, sowie eine Plasmaanregungsanordnung gemäß dem Oberbegriff von Anspruch 10.

Die Beschichtung von Substraten, z.B. Glasflächen mittels Sputtern/Kathodenzerstäuben in Plasmaprozessen, und zwar sowohl reaktiv als auch konventionell, ist z.B. aus der Architekturglasbeschichtung bekannt. Dazu wird mit einer Strom- oder Spannungsquelle ein Plasma erzeugt, das von einem Target Material abträgt, welches sich auf dem Substrat, z.B. der Glasscheibe, ablagert. Vor der Ablagerung können sich die Atome je nach gewünschter Beschichtung in einem reaktiven Prozess noch mit Gasatomen oder -molekülen verbinden.

Insbesondere bei reaktiven Prozessen werden häufig MF-Generatoren eingesetzt, die üblicherweise bei einer Frequenz von 10 - 500kHz arbeiten. Diese gibt es als so genannte frei schwingende MF-Generatoren oder als MF-Generatoren mit Festfrequenz. Die frei schwingenden MF-Generatoren sind in der Regel wie folgt aufgebaut: Aus einer Ein- oder Mehrphasenspannung des Versorgungsnetzes wird eine geregelte oder ungeregelte Gleichspannung, die Zwischenkreisspannung erzeugt. Die Zwischenkreisspannung wird mit einer Inverterschaltung (z.B. Brückenschaltung) zu einer Mittelfrequenz (MF)-Wechselspannung umgewandelt (10-500kHz). Das MF-Ausgangsleistungssignal wird auf einen Schwingkreis geschaltet, der zu einer Schwingung angeregt wird. Dabei wird der Inverter so betrieben, dass der Schwingkreis in der Nähe der Resonanzfrequenz betrieben wird. Der Schwingkreis kann ein Serienschwingkreis oder ein Parallelschwingkreis sein. Ein Serienschwingkreis wird mit einem Ausgangsleistungssignal mit einer Spannungsquellencharakteristik angeregt, wohingegen der Parallelkreis mit einem Ausgangsleistungssignal mit einer Stromquellencharakteristik angeregt wird. Um aus der Zwischenkreisspannung, die üblicherweise Spannungsquellencharakteristik besitzt, eine Stromquellencharakteristik zu generieren, werden Drosseln mit genügend großer Induktivität in Serie mit dem Inverter geschaltet. Üblicherweise wird die MF-Leistung an der Spule des Schwingkreises ausgekoppelt und an zwei Elektroden in einer Beschichtungskammer einer Beschichtungsanlage angeschlossen, so dass in der Beschichtungskammer ein Plasma erzeugt werden kann. Die Auskopplung kann über einen Ausgangstransformator erfolgen, der für die galvanische Trennung vom Netz sorgt. Die Elektroden arbeiten bei einem MF-Anregungssystem abwechselnd als Anode und Kathode. Die Resonanzfrequenz des Schwingkreises ist abhängig von der Impedanz des Plasmas. Damit der Inverter immer in der Nähe der Resonanzfrequenz betrieben wird, muss die Steuerung für den Inverter die Periodendauer oder die Dauer einer Halbwelle des MF-Ausgangsleistungssignals überwachen. Sie nimmt die Dauer der Periode bzw. der Halbwelle als Maß für die Zeitdauer des nächsten Umschaltens des Inverters. Wenn sich die Dauer der Periode bzw. einer Halbwelle ändert, so ist dies ein Zeichen dafür, dass sich die Plasmaimpedanz geändert hat.

Dies ist z. B. aus der DE 101 54 229 A1 bekannt. Beschrieben wird eine Einrichtung zur Regelung einer Plasmaimpedanz, bei der einem frei schwingenden Wechselstromgenerator ein Frequenzsollwert vorgegeben wird und der Frequenz-Istwert gemessen wird und in Abhängigkeit von der Differenz von Sollwert zu Istwert die Plasmaimpedanz beeinflusst wird.

Insbesondere bei reaktiven Prozessen kommt es auch bei MF-Generatoren zu Überschlägen, die oft mit der nächsten Spannungsumkehr oder zumindest nach wenigen Perioden von selbst verlöschen, zu so genannten Micro-Arcs. Es können aber auch energiereichere und länger andauernde Arcs auftreten. Bisher wurden alle Arcs erkannt durch Überprüfen der Ausgangsspannung auf einen Spannungseinbruch oder durch Überprüfen des Ausgangsstroms auf einen Stromanstieg. Alternativ kann ein Arc an der Differenz zwischen den Strömen zu den einzelnen Elektroden erkannt werden. Ein Grenzwert für die Erkennung von Arcs kann im Stand der Technik vom Betreiber eingestellt werden. Für die Erkennung werden die effektiven Werte von Strom und Spannung gemessen. Da eine solche Messung die Spannungswerte und Stromwerte über die Periode betragsmäßig aufintegrieren muss, um nicht Nulldurchgänge als Spannungsabsenkungen zu erkennen, ist diese Art der Erkennung eines Arcs in der Regel deutlich langsamer als die Dauer einer Halbwelle der MF - Ausgangsspannung und damit länger als 40µs.

Bei der Verwendung der MF - Generatoren im Halbleiterfertigungsprozess, insbesondere in der Flat-Panel-Display FPD - Herstellung, werden aber erhöhte Anforderungen an die Generatoren gestellt. Hier sollen Arcs innerhalb weniger µs erkannt werden.

Aus der WO 99/14394 A1 ist ein Verfahren zur Arcerkennung in einem Plasmasystem bekannt, wobei ein mit der Leistung in Beziehung stehendes Signal abgegriffenen werden kann. Das abgegriffene Signal wird in ein analoges Signal umgewandelt, das analoge Signal wird in ein digitales Signal gewandelt und das digitale Signal wird in Frequenzbänder umgewandelt. Dabei wird überprüft, ob ein Frequenzband-Signal einen vorgegebenen Wert überschreitet. In Abhängigkeit von diesem Vergleichsergebnis wird ein Arc erkannt.

In der EP 1 441 576 A1 ist ebenfalls ein Verfahren zur Arcerkennung beschrieben. Dabei werden ein in die Plasmakammer geliefertes Spannungssignal und ein von der Plasmakammer stammendes Spannungssignal analysiert und ein Arc erkannt, wenn das Verhältnis der Spannungssignale einen vorgegebenen Wert überschreitet.

Aus der US 6,420,863 B1 ist ein Verfahren zur Überwachung einer Wechselspannungs-Entladung zwischen den Elektroden einer Doppelelektrode, insbesondere zwischen zwei Targets für die Kathodenzerstäubung, bekannt, bei dem der Entladungsstrom und/oder die Entladungsspannung jeder der beiden Halbwellen innerhalb einer Periode der Wechselspannungs-Entladung gemessen wird bzw. werden und die Differenz zwischen den jeweiligen Messwerten der zweiten Halbwelle und den entsprechenden Messwerten der ersten Halbwelle mit spezifischen Toleranzvorgaben verglichen wird und bei Überschreitung der Toleranzvorgaben die Energiezufuhr derart abgesenkt wird, dass die Entladung kurzzeitig erlischt.

Aufgabe der vorliegenden Erfindung ist es, ein Verfahren und eine Vorrichtung für eine noch schnellere Arcerkennung bereitzustellen.

Diese Aufgabe wird mit einem Verfahren mit den Merkmalen des Anspruch 1 und einer Plasmaanregungsanordnung mit den Merkmalen des Anspruchs 10 gelöst.

Während es im Stand der Technik bekannt ist, ein Ausgangssignal zu überwachen und aus der Überwachung auf Plasmaimpedanzänderungen zu schließen und gegebenenfalls den Plasmaprozess anzupassen, ist es mit dem erfindungsgemäßen Verfahren möglich, das Auftreten von Arcs im Plasmaprozess schnell zu erkennen und gegebenenfalls darauf zu reagieren. Als mit dem Ausgangssignal in Beziehung stehendes internes Signal kommt beispielsweise ein Ausgangssignal eines Inverters des Wechselstromgenerators infrage, das auf einen Ausgangsschwingkreis des Wechselstromgenerators gegeben wird. Als mit dem zeitlichen Verlauf in Beziehung stehende Größe kommen beispielsweise die Frequenz, die Periodendauer oder das Frequenzspektrum des Ausgangssignals bzw. des mit dem Ausgangssignal in Beziehung stehenden internen Signals infrage. Mit diesem Verfahren ist eine extrem schnelle Arcerkennung möglich. Insbesondere kann ein Arc innerhalb einer halben Periodendauer, d.h. innerhalb von 40 µs erkannt werden.

Als mit dem zeitlichen Verlauf des Ausgangssignals oder des internen Signals in Beziehung stehende Größe wird die Dauer von Halbwellen des Ausgangssignals ermittelt. Bei frei schwingenden MF- Wechselstromgeneratoren ist eine Nulldurchgangserkennung der Ausgangsspannung ohnehin realisiert. Die Nulldurchgangserkennung wird für die Steuerung eines Inverters benötigt. Diese Nulldurchgangserkennung kann dazu genutzt werden, Arcs innerhalb der Dauer einer Halbwelle zu erkennen.

Bei einer besonders bevorzugten Verfahrensvariante kann vorgesehen sein, dass bei Erkennen eines Arcs die Leistungszufuhr zum Plasmaprozess unterbrochen wird, insbesondere für eine vorgebbare Zeitspanne unterbrochen wird. Dadurch kann die Restenergie im Ausgangsschwingkreis ausschwingen und werden Arcs nicht zusätzlich mit Energie versorgt. Dies führt zu einem raschen Löschen von Arcs und damit zu geringen Beschädigungen in der Plasmakammer. Die Leistungszufuhr zum Plasmaprozess kann unterbrochen werden, indem die den Eingang eines Inverters des Wechselstromgenerators bildenden Leitungen kurzgeschlossen oder niederohmig verbunden werden. Dies ist möglich, wenn der Strom von einer Zwischenkreisspannung zu einem Inverter begrenzt ist, wie dies beispielsweise bei MF-Generatoren mit Parallelschwingkreis am Ausgang häufig durch Drosseln erreicht wird. Alternativ ist es möglich, dass der Inverter so geschaltet wird, dass der vom Netzteil kommende, zumindest zwei Leitungen unterschiedlichen Potenzials aufweisende Strompfad kurzgeschlossen oder niederohmig verbunden wird.

Es ist denkbar, dass die Dauer der Halbwellen ermittelt wird, indem die Nulldurchgänge des Ausgangssignals oder des internen Signals erfasst werden und die zeitliche Differenz zwischen zwei Nulldurchgängen bestimmt wird. Alternativ kann die Dauer der Halbwellen aus der Periode oder der Frequenz des Ausgangssignals ermittelt werden. Weiterhin ist es denkbar, die Zeitdauer zischen zwei Maxima des Ausgangssignals zu ermitteln.

Der Zeitabstand von einem Nulldurchgang zum nächsten Nulldurchgang kann jedoch besonders einfach ermittelt werden. Der Inverter wird passend zum nächsten Nulldurchgang umgepolt, dabei werden Totzeiten der Inverterschaltung berücksichtigt, weshalb das Umpolen des Inverters nach Ablauf einer etwas kürzeren Zeit beginnt, als die Zeit, die für die Dauer der Halbwelle zuvor gemessen wurde. Gleichzeitig wird der tatsächliche Nulldurchgang der Spannung wieder überwacht und die tatsächliche Zeit bis zum Nulldurchgang wieder ermittelt. Bei langsamen Impedanzänderungen ändert sich die Zeitdauer von Nulldurchgang zu Nulldurchgang ebenfalls langsam. Eine plötzliche erhebliche Änderung, vor allem eine Verkürzung der Zeitdauer von einem Nulldurchgang zum nächsten Nulldurchgang, ist ein sicherer Hinweis auf einen Arc im Plasma. Daher ist es besonders vorteilhaft, wenn die Dauer der aktuellen Halbwelle als Referenzgröße bestimmt wird.

Alternativ ist es denkbar, als Referenzgröße die Differenz oder das Verhältnis zweier Halbwellendauern zu bestimmen, insbesondere der aktuellen Halbwellendauer und der vorhergehenden Halbwellendauer. Wenn mehrere Halbwellendauern ermittelt werden, kann auch die Periode ermittelt werden und kann ein auf die Periode normierter Wert als Referenzgröße bestimmt werden.

Um auszuschließen, dass erlaubte Impedanzschwankungen zum Erkennen eines Arcs führen, kann vorgesehen sein, dass bei der Ermittlung der Referenzgröße mehrere Halbwellendauern berücksichtigt werden, insbesondere ein vorzugsweise gewichteter Mittelwert von Halbwellendauern der Vergangenheit berücksichtigt wird.

Das Verfahren lässt sich besonders einfach und mit geringem Rechenaufwand durchführen, wenn als Schwellenwert eine Größe fest vorgegeben wird.

Eine zuverlässigere Arcerkennung ergibt sich jedoch, wenn der Schwellenwert plasmaprozessabhängig bestimmt wird. Somit kann ausgeschlossen werden, dass zulässige Impedanzschwankungen zu einem Erkennen eines Arcs führen und somit der Plasmaprozess unnötig oft unterbrochen wird.

Eine besonders einfache plasmaprozessabhängige Anpassung des Schwellenwerts ergibt sich, wenn die Periode des Ausgangssignal oder des internen Signals bestimmt wird und der Schwellenwert in Abhängigkeit von der Periode bestimmt wird. Bei einem frei schwingenden Wechselstromgenerator ist die Frequenz und damit die Periode des Ausgangssignals ein Maß für die Impedanz des Plasmaprozesses. Sie ändert sich daher bei einer Änderung der Impedanz und somit beim Auftreten eines Arcs. Dabei kann die letzte ermittelte Periode verwendet werden oder eine aus einer vorgebbaren Anzahl von vorhergehenden Perioden gemittelte Periode verwendet werden. Insbesondere kann die Periode des Ausgangssignals ständig erfasst und aktualisiert werden. Weiterhin ist es denkbar, eine normierte Periode des Ausgangssignals oder des internen Signals zu verwenden. Die Periode kann auch aus einer vorgebbaren Anzahl von erfassten Halbwellendauern ermittelt werden.

Vorrichtungsmäßig betrifft die Erfindung eine Plasmaanregungsanordnung mir einem insbesondere frei schwingenden Wechselstromgenerator, der an einen Plasmaprozess, d.h. Elektroden einer Plasmakammer, anschließbar ist, mit einer Signalüberwachungseinrichtung zur Überwachung des zeitlichen Verlaufs eines Ausgangssignals oder eines internen Signals des Wechselstromgenerators, wobei eine Referenzgrößenermittlungseinrichtung vorgesehen ist, die mit der Signalüberwachungseinrichtung und einem Vergleicher verbunden ist, und eine Schwellwertvorgabeeinrichtung vorgesehen ist, die ebenfalls mit dem Vergleicher verbunden ist, wobei der Vergleicher mit Mitteln zur Erzeugung eines Abschaltsignals, insbesondere des Wechselstromgenerators, verbunden ist oder solche aufweist. Mit einer derartigen Anordnung können Arcs in einem Plasmaprozess schnell erkannt werden und kann die Leistungszufuhr zum Plasmaprozess schnell unterbunden werden. Der zeitliche Verlauf kann insbesondere dadurch überwacht werden, dass die Nulldurchgänge des Ausgangssignals oder des internen Signals erfasst werden. Alternativ kann die Frequenz oder Periodendauer des Ausgangssignals oder des internen Signals überwacht werden. Durch das Abschaltsignal kann die Unterbrechung der Energiezufuhr zur Plasmakammer bewirkt werden.

Bei einer bevorzugten Ausführungsform ist eine Steuereinrichtung zur Steuerung des Wechselstromgenerators vorgesehen, wobei die Referenzgrößenermittlungseinrichtung und der Vergleicher in der Steuereinrichtung angeordnet sein können.

Bei einer vorteilhaften Ausgestaltung der Erfindung sind die Signalüberwachungseinrichtung als Komparatorschaltung und die Referenzgrößenermittlungseinrichtung als Prozessor, insbesondere als digitaler Signalprozessor, ausgebildet.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein. Bevorzugte Ausführungsbeispiele der Erfindung sind in der Zeichnung schematisch dargestellt und werden nachfolgend mit Bezug zu den Figuren der Zeichnung näher erläutert. Es zeigt:
- Fig. 1: eine schematische Darstellung einer Plasmaanregungsanordnung;
- Fig. 2a: eine Darstellung eines Ausgangssignalsverlaufs ohne Auftreten eines Arcs;
- Fig. 2b: eine Darstellung eines Ausgangssignalverlaufs mit Auftreten eines Arcs;
- Fig. 3: eine Detaildarstellung eines Inverters der Plasmaanregungsanordnung.

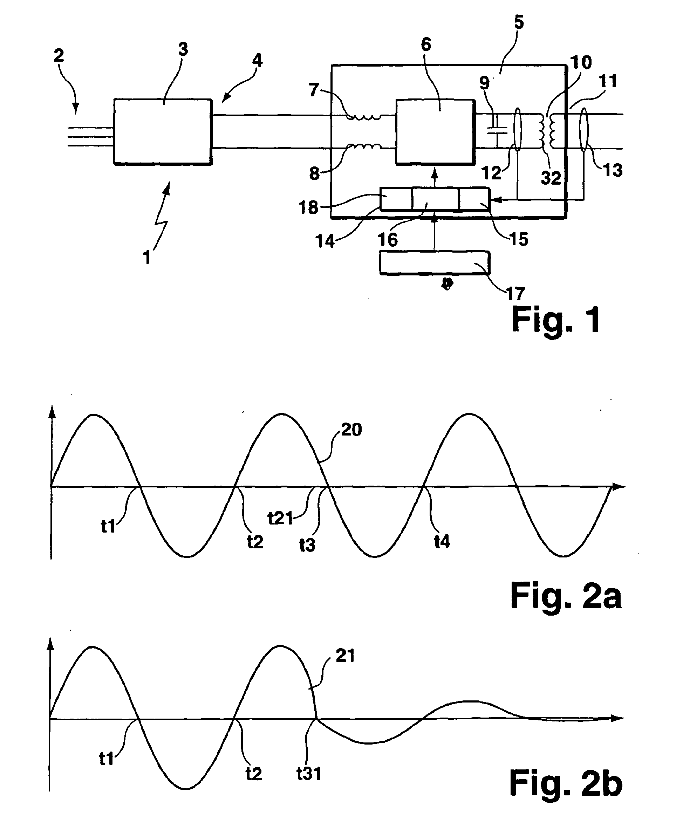

In der Fig. 1 ist eine Plasmaanregungsanordnung 1 dargestellt, die über einen Netzanschluss an 2 an eine Mehrphaseneingangsspannung anschließbar ist. Über den Netzanschluss 2 ist eine DC-Stromversorgung 3 an die Mehrphaseneingangsspannung angeschlossen, um an ihrem Ausgang 4 eine Zwischenkreisspannung zu erzeugen. Dazu kann die DC-Stromversorgung 3 einen Netzgleichrichter und einen DC/DC-Wandler aufweisen.

Ein als Mittelfrequenz (MF) - Einheit ausgebildeter Wechselstromgenerator 5 wird durch die Zwischenkreisspannung gespeist. Insbesondere ist ein Inverter 6 über Drosseln 7, 8 an die Zwischenkreisspannung angeschlossen. In dem Inverter 6 wird eine Wechselspannung erzeugt Diese Wechselspannung ist als internes Signal am Ausgang des Inverters 6 vorhanden. Eine galvanische Trennung wird durch einen Ausgangsübertrager 10 realisiert, der die Wechselspannung des Inverters 6 in ein Ausgangssignal am Ausgang 11 des Wechselstromgenerators 5 transformiert. Ein Kondensator 9 und die Streuinduktivität des Ausgangsübertragers 10 ergeben einen Parallelresonanzkreis, der einen Ausgangsschwingkreis darstellt. Das Ausgangssignal kann einer nicht dargestellten Plasmakammer zugeführt werden.

Über Signalüberwachungseinrichtungen 12, 13 können das interne und/oder das Ausgangssignal erfasst werden. Die Signalüberwachungseinrichtungen 12, 13 sind mit einer Steuereinrichtung 14 verbunden. Die Steuereinrichtung 14 umfasst eine Referenzgrößenermittlungseinrichtung 15, um aus dem ermittelten internen Signal oder Ausgangssignal bzw. einem mit dem zeitlichen Verlauf der Signale zusammenhängenden Signal eine Referenzgröße zu ermitteln. Diese Referenzgröße wird in einem Vergleicher 16 mit einem Schwellenwert verglichen, der von einer Schwellenwertvorgabeeinrichtung 17 vorgegeben wird. Der Vergleicher 16 steuert Mittel 18 zur Generierung eines Abschaltsignals in Abhängigkeit von dem Vergleichsergebnis an. Durch das Abschaltsignal kann Unterbrechung der Energiezufuhr zur Plasmakammer bewirkt werden.

In der Fig. 2a ist beispielhaft ein Verlauf eines Ausgangssignals 20 des Wechselstromgenerators 5 gezeigt. Durch die Signalüberwachungseinrichtung 13 werden die Nulldurchgänge t1 - t4 detektiert. Beispielsweise generiert ein Komparator in der Signalüberwachungseinrichtung 13 eine Flanke bzw. eine Pegeländerung eines Signals bei jedem Nulldurchgang t1, t2, t3, t4 des überwachten Signals. Der Zeitabstand von einem Nulldurchgang t1 - t4 zum nächsten Nulldurchgang t1 - t4 wird ermittelt. Der Inverter 6 wird passend zum nächsten Nulldurchgang umgepolt, dabei werden Totzeiten der Inverterschaltung berücksichtigt, weshalb das Umpolen des Inverters 6 nach Ablauf einer etwas kürzeren Zeit beginnt, als die Zeitdauer, die für die vorhergehende Halbwelle gemessen wurde (Inverterumpolung z.B. zum Zeitpunkt t21). Gleichzeitig wird der tatsächliche Nulldurchgang t1 - t4 des Ausgangssignals 20, insbesondere der Ausgangsspannung, wieder überwacht und die tatsächliche Zeit bis zum Nulldurchgang t1 - t4 wieder ermittelt. Bei langsamen Impedanzänderungen ändert sich die Zeitdauer von Nulldurchgang t1 - t4 zu Nulldurchgang t1 - t4 ebenfalls langsam. Eine plötzliche erhebliche Änderung, vor allem eine Verkürzung der Zeitdauer von einem Nulldurchgang zum nächsten Nulldurchgang, wie z.B. von t2 zu t31 des Ausgangssignals 21 in Fig. 2b ist ein sicherer Hinweis für das Auftreten eines Arcs im Plasma. Der Schwellenwert, ab dem ein Arc erkannt werden soll, kann eingestellt werden bzw. durch die Schwellenwertvorgabeeinrichtung 17 vorgegeben werden.

Aus dem Vorstehenden ergibt sich, dass die gemessene Dauer einer Halbwelle als Referenzgröße verwendet werden kann, die mit einem Schwellenwert verglichen wird. Alternativ kann die Differenz Δt = (t3-t2) - (t2-t1) (Fig. 2a) bzw. Δt = (t31-t2) - (t2-t1) (Fig. 2b) berechnet werden. Wenn diese Differenz um mehr als einen vorgegebenen Schwellenwert von 0 abweicht (Fig. 2b), deutet dies auf das Vorhandensein eines Arcs im Plasma hin.

Die Referenzgrößen können auch auf die Periodendauer T normiert werden. Dabei kann die Periodendauer T ständig berechnet werden, damit 'erlaubte' Impedanzschwankungen nicht zum Erkennen eines Arcs führen.

Da Nulldurchgänge mit einer Komparatorschaltung sehr einfach digital erkannt werden können und Flanken von Mikro-Prozessoren, z.B. digitalen Signalprozessoren sehr leicht und schnell ausgewertet werden können, ist eine digitale Steuereinrichtung 17 in Verbindung mit der Arcerkennung vorteilhaft.

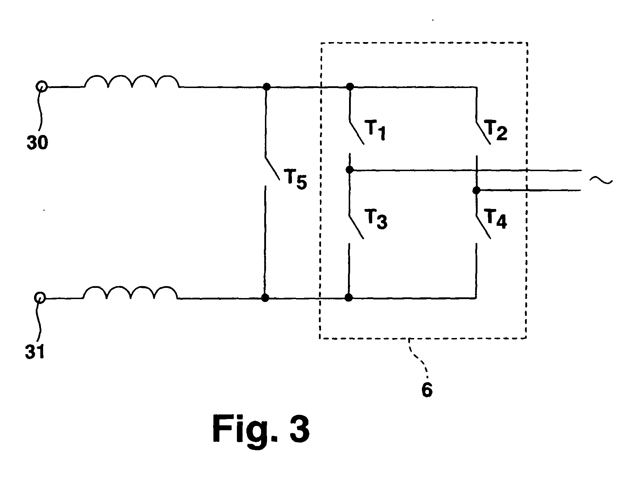

In der Fig. 3 ist eine Detaildarstellung eines Inverters 6 gezeigt. Der Inverter 6 weist eine Vollbrücke auf, die aus vier als Transistoren ausgebildeten schaltenden Elementen T1 - T4 besteht. Diese schaltenden Elemente T1 - T4 werden durch die Steuereinrichtung 14 angesteuert. Zur Unterbrechung der Leistungszufuhr in die Plasmakammer sind verschiedene Szenarien denkbar. Zum einen ist es denkbar, die schaltenden Elemente T1 und T3 leitend zu schalten, um den Strom von der DC-Stromversorgung 3 kurzzuschließen bzw. die Klemmen 30, 31 kurz zu schließen oder niederohmig zu verbinden.

Zum anderen ist es denkbar, die schaltenden Elemente T2 und T4 für den gleichen Effekt durchzuschalten.

Werden die schaltenden Elemente T1, T2 oder T3, T4 oder alle schaltenden Elemente T1 - T4 so angesteuert, dass sie leitend sind, wird der Ausgangsschwingkreis, bestehend aus dem Kondensator 9 und der Primärinduktivität 32 des Ausgangsübertragers 10, kurzgeschlossen, so dass auf diese Weise die Leistungszufuhr zur Plasmakammer unterbrochen wird.

Um die Leistungszufuhr unterbrechen zu können, kann weiterhin ein schaltendes Element T5 zwischen den Klemmen 30, 31 bzw. am Eingang des Inverters 6 angeordnet sein. Die schaltenden Elemente T1 - T5 können durch die Steuereinrichtung 17, insbesondere durch die Mittel 18 zur Generierung eines Abschaltsignals, angesteuert sein.

## Patentansprüche

1. Verfahren zur Arcerkennung in einem Plasmaprozess, der von einem Wechselstromgenerator (5) mit einem Ausgangssignal (20, 21) des Wechselstromgenerators (5) zur Leistungszufuhr gespeist wird, wobei eine mit dem zeitlichen Verlauf des Ausgangssignals (20, 21) oder eines mit dem Ausgangssignal (20, 21) in Beziehung stehenden internen Signals des Wechselstromgenerators (5) in Beziehung stehende Größe gemessen oder ermittelt wird, wobei unter Berücksichtigung des zeitlichen Verlaufs eine Referenzgröße bestimmt wird, die Referenzgröße mit einem Schwellenwert verglichen wird und bei einem vorgegebenen Vergleichsergebnis ein Arc erkannt wird, **dadurch gekennzeichnet, dass** als mit dem zeitlichen Verlauf des Ausgangssignals (20, 21) oder des internen Signals in Beziehung stehende Größe die Dauer von Halbwellen des Ausgangssignals (20, 21) oder des internen Signals ermittelt wird.

2. Verfahren nach Anspruch 1, **dadurch gekennzeichnet, dass** bei Erkennen eines Arcs die Leistungszufuhr zum Plasmaprozess unterbrochen wird, insbesondere für eine vorgebbare Zeitspanne unterbrochen wird.

3. Verfahren nach Anspruch 1 oder 2, **dadurch gekennzeichnet, dass** die Dauer der Halbwellen ermittelt wird, indem die Nulldurchgänge des Ausgangssignals (20, 21) oder des internen Signals erfasst werden und die zeitliche Differenz zwischen zwei Nulldurchgängen (t1 - t4, t31) bestimmt wird.

4. Verfahren nach einem der vorhergehenden Ansprüche, **dadurch gekennzeichnet, dass** die Dauer der aktuellen Halbwelle als Referenzgröße bestimmt wird.

5. Verfahren nach einem der vorhergehenden Ansprüche 1 - 3, **dadurch gekennzeichnet, dass** als Referenzgröße die Differenz oder das Verhältnis zweier Halbwellendauern bestimmt wird, insbesondere der aktuellen Halbwellendauer und der vorhergehenden Halbwellendauer.

6. Verfahren nach einem der vorhergehenden Ansprüche 1 - 3, **dadurch gekennzeichnet, dass** bei der Ermittlung der Referenzgröße mehrere Halbwellendauern berücksichtigt werden, insbesondere ein vorzugsweise gewichteter Mittelwert von Halbwellendauern der Vergangenheit berücksichtigt wird.

7. Verfahren nach einem der vorhergehenden Ansprüche, **dadurch gekennzeichnet, dass** als Schwellenwert eine Größe fest vorgegeben wird.

8. Verfahren nach einem der vorhergehenden Ansprüche, **dadurch gekennzeichnet, dass** der Schwellenwert plasmaprozessabhängig bestimmt wird.

9. Verfahren nach einem der vorhergehenden Ansprüche, **dadurch gekennzeichnet, dass** die Periode des Ausgangssignal (20, 21) oder des internen Signals bestimmt wird und der Schwellenwert in Abhängigkeit von der Periode bestimmt wird.

10. Plasmaanregungsanordnung (1) mit einem Wechselstromgenerator (5), der an einen Plasmaprozess anschließbar ist, mit einer Signalüberwachungseinrichtung (12, 13) zur Überwachung des zeitlichen Verlaufs eines Ausgangssignals (20, 21) oder eines internen Signals des Wechselstromgenerators (5), wobei eine Referenzgrößenermittlungseinrichtung (15) vorgesehen ist, die mit der Signalüberwachungseinrichtung (12, 13) und einem Vergleicher (16) verbunden ist, und eine Schwellenwertvorgabeeinrichtung (17) vorgesehen ist, die ebenfalls mit dem Vergleicher (16) verbunden ist, wobei der Vergleicher mit Mitteln (18) zur Erzeugung eines Abschaltsignals verbunden ist, **dadurch gekennzeichnet, dass** die Referenzgrößenermittlungseinrichtung (15) geeignet ist, die Dauer der Halbwellen des Ausgangssignals (20, 21) oder des internen Signals zu erfassen.

11. Plasmaanregungsanordnung nach Anspruch 10, **dadurch gekennzeichnet, dass** eine Steuereinrichtung (17) zur Steuerung des Wechselstromgenerators (5) vorgesehen ist, wobei die Referenzgrößenermittlungseinrichtung (15) und der Vergleicher (16) in der Steuereinrichtung (17) angeordnet sind.

12. Plasmaanregungsanordnung nach Anspruch 10 oder 11, **dadurch gekennzeichnet, dass** die Signalüberwachungseinrichtung (12, 13) als Komparatorschaltung und die Referenzgrößenermittlungseinrichtung (15) als Prozessor, insbesondere als digitaler Signalprozessor, ausgebildet sind.

## Claims

1. A method of arc detection in a plasma process which is supplied by an AC generator (5) with an output signal (20, 21) of the AC generator (5) for supplying power, wherein a value which is in correlation with the time response of the output signal (20, 21) or of an internal signal of the AC generator (5) is measured or ascertained, which internal signal is in correlation with the output signal (20, 21), wherein a reference value is determined, taking the time response into consideration, the reference value is compared with a threshold value and, if a predetermined comparison result is obtained, an arc is detected, **characterised in that** the duration of half-waves of the output signal (20, 21) or the internal signal is ascertained as the value which is in correlation with the time response of the output signal (20, 21) or the internal signal.

2. A method according to claim 1, **characterised in that**, upon detection of an arc, the power supply to the plasma process is interrupted, especially for a predeterminable time interval.

3. A method according to claim 1 or 2, **characterised in that** the duration of the half-waves is ascertained by detecting the zero crossings of the output signal (20, 21) or the internal signal and by determining the time difference between two zero crossings (t1 - t4, t31).

4. A method according to any one of the preceding claims, **characterised in that** the duration of the present half-wave is determined as a reference value.

5. A method according to any one of the preceding claims 1 to 3, **characterised in that** the difference or the ratio between two half-wave durations, especially the present half-wave duration and the preceding half-wave duration, is determined as a reference value.

6. A method according to any one of the preceding claims 1 to 3, **characterised in that**, in ascertaining the reference value, a plurality of half-wave durations are taken into consideration, in particular a preferably weighted average value of previous half-wave durations is taken into consideration.

7. A method according to any one of the preceding claims, **characterised in that** a value is fixedly predetermined as the threshold value.

8. A method according to any one of the preceding claims, **characterised in that** the threshold value is determined in dependence upon the plasma process.

9. A method according to any one of the preceding claims, **characterised in that** the period of the output signal (20, 21) or the internal signal is determined and the threshold value is determined in dependence on the period.

10. A plasma excitation arrangement (1) with an AC generator (5) which is connectable to a plasma process, with a signal monitoring device (12, 13) for monitoring the time response of an output signal (20, 21) or an internal signal of the AC generator (5), wherein a reference-value determining device (15) is provided which is connected to the signal monitoring device (12, 13) and to a comparator (16), and a threshold-value presetting device (17) is provided which is likewise connected to the comparator (16), wherein the comparator is connected to means (18) for generating a shut-down signal, **characterised in that** the reference-value determining device (15) is suitable for detecting the duration of the half-waves of the output signal (20, 21) or the internal signal.

11. A plasma excitation arrangement according to claim 10, **characterised in that** a control device (17) is provided for controlling the AC generator (5), wherein the reference-value determining device (15) and the comparator (16) are arranged in the control device (17).

12. A plasma excitation arrangement according to claim 10 or 11, **characterised in that** the signal monitoring device (12, 13) is formed as a comparator circuit and the reference-value determining device (15) is formed as a processor, especially a digital signal processor.

## Revendications

1. Procédé de détection d'arc dans un procédé plasma qui est alimenté par un générateur de courant alternatif (5) avec un signala de sortie (20, 21) du générateur de courant alternatif (5) pour l'amenée de puissance, dans lequel une grandeur en relation avec la variation dans le temps du signal de sortie (20, 21) ou d'un signal interne du générateur de courant alternatif (5) en relation avec le signal de sortie (20, 21) est mesurée ou déterminée, dans lequel une grandeur de référence est définie en tenant compte de la variation dans le temps, la grandeur de référence est comparée avec une valeur seuil et un arc est détecté ou reconnu avec un résultat de comparaison prédéterminé, **caractérisé en ce que** la durée de demi-ondes du signal de sortie (20, 21) ou du signal interne est établie ou déterminée comme grandeur en relation avec la variation dans le temps du signal de sortie (20, 21) ou du signal interne.

2. Procédé selon la revendication 1, **caractérisé en ce que**, au moment de la détection d'un arc, l'amenée de puissance au procédé plasma est interrompue, notamment pendant une durée prédéterminable.

3. Procédé selon la revendication 1 ou 2, **caractérisé en ce que** la durée des demi-ondes est déterminée en détectant les passages par zéro du signal de sortie (20, 21) ou du signal interne et en déterminant la différence dans le temps entre deux passages par zéro (t1 - t4, t31).

4. Procédé selon l'une quelconque des revendications précédentes, **caractérisé en ce que** la durée de la demi-onde actuelle est définie comme grandeur de référence.

5. Procédé selon l'une quelconque des revendications 1 à 3, **caractérisé en ce que** la différence ou le rapport de deux durées de demi-ondes, notamment de la durée de la demi-onde actuelle et de la demi-onde précédente, est définie comme grandeur de référence.

6. Procédé selon l'une quelconque des revendications 1 à 3, **caractérisé en ce que**, pour déterminer la grandeur de référence, plusieurs durées de demi-ondes sont prises en compte, notamment une valeur moyenne, de préférence pondérée, de durées de demi-ondes du passé est prise en compte.

7. Procédé selon l'une quelconque des revendications précédentes, **caractérisé en ce qu'**une grandeur est prédéterminée de manière fixe comme valeur seuil.

8. Procédé selon l'une quelconque des revendications précédentes, **caractérisé en ce que** la valeur seuil est déterminée en fonction du procédé plasma.

9. Procédé selon l'une quelconque des revendications précédentes, **caractérisé en ce que** la période du signal de sortie (20, 21) ou du signal interne est définie et **en ce que** la valeur seuil est définie en fonction de la période.

10. Dispositif d'excitation plasma (1) avec un générateur de courant alternatif (5) qui peut être raccordé à un procédé plasma, avec un dispositif de surveillance de signal (12, 13) pour la surveillance de la variation dans le temps d'un signal de sortie (20, 21) ou d'un signal interne du générateur de courant alternatif (5), dans lequel est prévu un dispositif de détermination de grandeur de référence (15) qui est relié au dispositif de surveillance de signal (12, 13) et à un comparateur (16) et dans lequel est prévu un dispositif de prédétermination de valeur seuil (17) qui est également relié au comparateur (16), dans lequel le comparateur est relié à des moyens (18) destinés à générer un signal d'arrêt ou de coupure, **caractérisé en ce que** le dispositif de détermination de grandeur de référence (15) est conçu pour acquérir ou saisir la durée des demi-ondes du signal de sortie (20, 21) ou du signal interne.

11. Dispositif d'excitation plasma selon la revendication 10, **caractérisé en ce qu'**il est prévu un dispositif de commande (17) destiné à commander le générateur de courant alternatif (5), le dispositif de détermination de grandeur de référence (15) et le comparateur (16) étant disposés dans le dispositif de commande (17).

12. Dispositif d'excitation plasma selon la revendication 10 ou 11, **caractérisé en ce que** le dispositif de surveillance de signal (12, 13) est conçu comme un circuit comparateur et le dispositif de détermination de grandeur de référence (15) comme un processeur, notamment comme un processeur de signal numérique.
